# EUROPÄISCHE PATENTSCHRIFT

(11) **EP 0 847 595 B1**
(45) Veröffentlichungstag und Bekanntmachung des Hinweises auf die Patenterteilung: **10.11.2004**
(21) Anmeldenummer: 96934338.3
(22) Anmeldetag: 06.08.1996
(51) Int. Cl.: H01L 23/40

(54) **KÜHLKÖRPER FÜR ELEKTRONISCHE BAUELEMENTE**
COOLING ELEMENT FOR ELECTRONIC COMPONENTS
PUITS THERMIQUE POUR COMPOSANTS ELECTRONIQUES

(30) Priorität: 28.08.1995 DE 19531628
(43) Veröffentlichungstag der Anmeldung: 17.06.1998
(73) Patentinhaber: SIEMENS AKTIENGESELLSCHAFT, 80333 München (DE)
(72) Erfinder: KOHLER, Gerd, D-80639 München (DE); KIRMSE, Tobias, D-76684 Östringen (DE); KÖHLER, Klaus-Werner, D-67346 Speyer (DE); LUCKNER, Hans-Uwe, D-93049 Regensburg (DE)
(86) Internationale Anmeldenummer: PCT/DE1996/001469
(87) Internationale Veröffentlichungsnummer: WO 1997/008750

(56) Entgegenhaltungen:
- WO-A-91/05369
- DE-A- 4 335 299
- US-A- 4 605 058
- IBM TECHNICAL DISCLOSURE BULLETIN, Bd. 22, Nr. 1, Juni 1979, NEW YORK, Seiten 71-72, XP002022049 F. E. ANDROS ET AL.: "one-piece snap-on heat sink"

## Beschreibung

Die Erfindung betrifft einen Kühlkörper für elektronische Bauelemente, insbesondere einen auf der Oberseite eines Bauelementes montier- und ankoppelbaren Kühlkörper, der die Verlustwärme des Bauelementes aufnimmt und über Kühlflächen abgibt. Ein derartiger Kühlkörper steht in der Regel in Kontakt mit einem Wärmeverteiler (heat slug) des Bauelementes.

Für den zuverlässigen Einsatz von Halbleiterbauelementen ist eine gute Wärmeabfuhr unerläßlich. Mit zunehmender Leistungsdichte einhergehend mit immer kleiner werdenden Bauelementen und daraus resultierender steigender Verlustleistung, ergibt sich die Forderung nach immer leistungsfähigeren Kühlkörpern. Diese sollten zur internen Wärmeleitung eine gute Wärmeleitfähigkeit aufweisen und zur Abführung der Wärme nach außen eine große Oberfläche. Dabei erfolgt die Übertragung der Verlustleistung zunächst vom Halbleitergehäuse über Kontaktflächen auf den Kühlkörper. Innerhalb des Kühlkörpers geschieht die Wärmeverteilung über Wärmeleitung. Die Abgabe der Wärme nach außen hin geschieht mittels Strahlung bzw. Konvektion.

Bei kleiner werdenden zu kühlenden Oberflächen bei gleichzeitig hoher abzuführender Verlustleistung, wirken sich Unebenheiten der zu kühlenden Oberflächen zunehmend ungünstig auf die Wärmeübertragung vom Bauelement auf den Kühlkörper aus. Durch den Einsatz von Wärmeleitfolien können diese Unebenheiten ausgeglichen werden. Dies bedeutet jedoch einen erhöhten Aufwand von Material und Handhabundkosten.

Im Stand der Technik sind verschiedenartigste Ausbildungen von Kühlkörpern bekannt. So wird in der deutschen Offenlegungsschrift DE 43 35 299 ein Kühlkörper zur Verbindung mit einem Halbleitergehäuse vorgeschlagen, bei dem zwei gegenüberliegende Seiten klammerartig mit einem Gehäuse verbindbar sind. Der Kühlkörper weist Kühlrippen und eine Kontaktfläche auf, die zur Wärmeübertragung mit dem elektronischen Bauelement insbesondere mit dessen Oberseite in Kontakt steht.

Weitere Formen von Kühlkörpern sind beispielsweise bekannt aus der deutschen Offenlegungsschrift DE 24 25 723 oder aus der japanischen Patentanmeldung Nr. 64-23 11 04.

Die im Stand der Technik vorgeschlagenen Lösungen weisen die Nachteile auf, daß sie zu raumintensiv, zu kompliziert und damit zu teuer oder zu unzuverlässig sind, so daß die Kühlwirkung beispielsweise bei einer Erschütterung nachläßt oder ausfällt.

Der Erfindung liegt die Aufgabe zugrunde, einen kostengünstigen selbstzentrierenden gut fixierten und trotzdem nachgiebigen Kühlkörper mit hohem Wärmeableitungsvermögen bereitzustellen. Die Lösung dieser Aufgabe geschieht durch.die Merkmale des Anspruchs 1.

Vorteilhafte Ausgestaltungen können den Unteransprüchen entnommen werden.

Die Erfindung beruht auf der Erkenntnis, daß durch ein federndes, aus einem Blechstreifen mäanderförmig gebogenen Gebilde eines Kühlkörpers die optimale Lage von Kontaktflächen des Kühlkörpers auf dem Wärmeverteiler eines elektronischen Bauelementes nach dem Einwirken von Kräften erhalten werden kann, da der Kühlkörper unter Vorspannung steht. Darüber hinaus sorgen Schultern und Lappen im Bereich der Kontaktflächen des Kühlkörpers für eine wirksame Zentrierung bzw. Positionierung relativ zum Bauelement. Somit ist der Kühlkörper zwar elastisch und kann bestimmten mechanischen Beanspruchungen ausweichen, nimmt jedoch seine ursprüngliche Lage wieder ein, so daß die zuverlässige Wärmeabfuhr jederzeit gesichert ist. Der Flächenbedarf eines Kühlkörpers in der Draufsicht ist nur geringfügig größer als die Fläche des zu kühlenden Bauelementes. Zur Anpassung der Leistung der Wärmeabfuhr kann der Kühlkörper beliebig hoch bauen. Die erfindungsgemäße Lösung, daß der Kühlkörper durch ein StanzBiegeteil aus einem Blechstreifen hergestellt wird und mäanderförmig gebogen wird, bietet die Möglichkeit, entsprechende Kontaktflächen positionsgenau auf das Bauelement aufzusetzen, eine durch entsprechende Biegungen wirkende Vorspannung zu erzeugen, so daß eine Schnappverbindung den Kühlkörper mit seinen Kühlflächen auf das Bauelement zieht und daß die zur Zentrierung eingesetzten Schultern und Lappen einstückig an dem Streifen ausgebildet sind, d.h. in entsprechender Weise gestanzt und gebogen sind.

Im folgenden wird anhand von schematischen Figuren 1 bis 5 ein Ausführungsbeispiel beschrieben.

Die Figuren 1 bis 3 zeigen das Prinzip der Kühlkörpermontage. Dabei ist der Kühlkörper nach Figur 1 im Ruhezustand, derjenige nach Figur 2 im aufgesetzten, aber nicht fertig montierten Zustand und der entsprechend Figur 3 im fertig montierten Zustand.

Figur 4 zeigt eine detaillierte Darstellung der beidseitig am Bauelement vorgesehenen Einschnappverbindung zwischen Kühlkörper und Bauelement.

Figur 5 zeigt die Ansicht des Kühlkörpers von unten, wobei verdeckte Teile, wie Kontaktflächen oder Nasen, mitberücksichtigt sind.

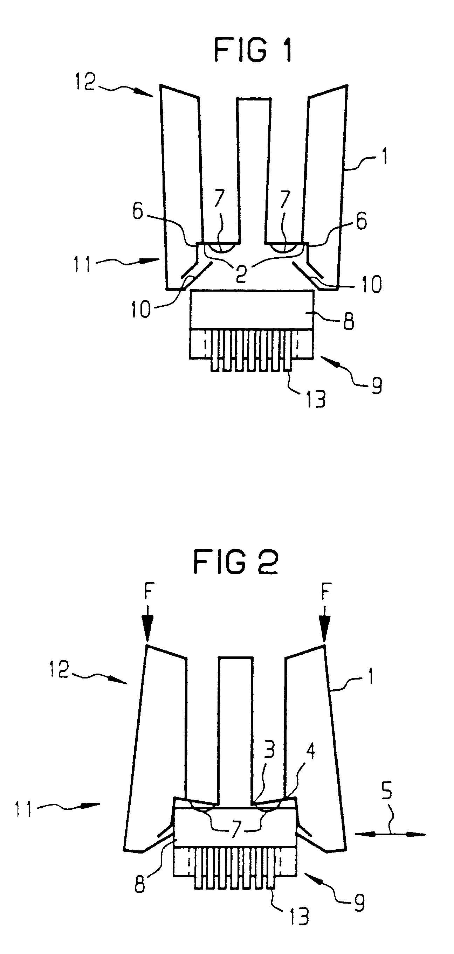

In den Figuren 1 bis 3 ist jeweils in der Seitenansicht ein elektronisches Bauelement 9 mit entsprechenden elektrischen Anschlüssen 13 zusammen mit einem darüber befindlichen Kühlkörper 1 dargestellt. Das elektronische Bauelement 9 weist einen sogenannten Wärmeverteiler (heat slug) auf. Dieser kann auf der Oberseite des Bauelementes 9 ganzflächig oder partiell oder auch in Randbereichen, d.h. an den Seitenflächen des Bauelementes 9 vorhanden sein bzw. nach außen kontaktiert werden. Der Kühlkörper 1 ist einstückig gefertigt mit sämtlichen in den Figuren 1 bis 3 sichtbaren Elementen. Dazu werden in einen Blechstreifen aus Messing die Konturen von Schultern 6, Lappen 7 und Nasen 10 freigestanzt. Beim Biegen erhält der Kühlkörper 1 die dargestellte Mäanderform. Die Schultern 6 und Lappen 7 werden entsprechend dem oberen Umriß des Wärmeverteilers 8 derart gebogen, daß sie zur Zentrierung bzw. Positionierung relativ zu dem Wärmeverteiler 8 dienen. Zur Selbstzentrierung beim Aufsetzen des Kühlkörpers 1 auf ein Bauelement sind die Schultern 6 an ihren Enden entsprechend trichterförmig nach außen gebogen. Die Lappen 7 begrenzen den seitlichen Lagebereich des Kühlkörpers 1 auf dem Bauelement 9. Zur Vereinfachung der Montage ist der Abstand der Lappen 7 größer als die korrespondierende Breite des Bauelementes 9.

In Figur 1 ist der Kühlkörper 1 noch nicht auf dem Bauelement 9 aufgesetzt. Die unteren Mäanderbögen 11 enthalten in dieser Ausführungsform die Kontaktflächen 2, die auf dem Wärmeverteiler 8 aufsitzen sollen. Die Mäanderform wird in diesem Fall durch Biegungen dargestellt, die im Bereich von 90° liegen. Die äußeren der oberen Mäanderbögen sind - wie in Figur 1 dargestellt - ausgebildet, um bei der Montage die Einleitung der Fügekräfte F auf einfache Art und Weise sicherzustelllen.

Die nach der Herstellung der Schnappverbindung zwischen Kühlkörper 1 und Bauelement 9 im Kühlkörper 1 verbleibende Spannung bewirkt einen sicheren Halt und ein Andrücken der Kontaktflächen 2 auf den Wärmeverteiler 8.

Mit den oben beschriebenen, durch entsprechende Biegungen bewirkten Verhältnissen läßt sich der Kühlkörper 1 mittels der Fügekräfte F, die senkrecht von oben angreifen, auf das Bauelement bzw. auf den Wärmeverteiler 8 aufsetzen. Dabei setzen zunächst die Kontaktflächen 2 teilweise oder vollständig auf der Oberseite des Bauelementes auf. Durch die Schultern 6 wird der Kühlkörper 1 relativ zum Bauelement 9 zentriert bzw. positioniert. Die beiden äußeren Schenkel des Kühlkörpers 1 werden durch die nach innen und oben geführten Nasen 10 nach außen gedrückt. In dem Zustand entsprechend Figur 2 ist der Kühlkörper 1 noch nicht vollständig montiert.

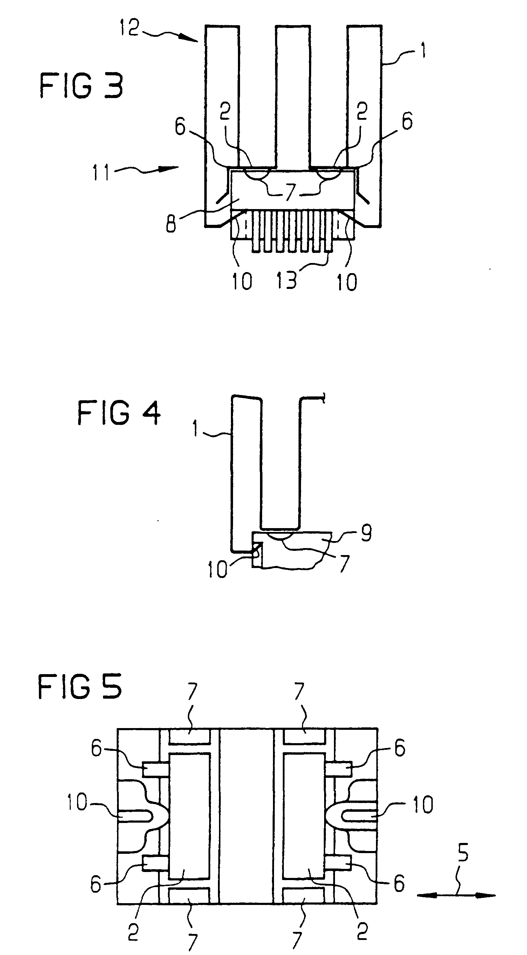

Die Figur 3 zeigt ein System mit einem vollständig auf einem Bauelement 9 montierten Kühlkörper 1. Die Kontaktflächen 2 sitzen vollständig auf der Oberseite des Bauelementes 9 auf. Die Schultern 6 legen sich an den Rand des oberen Teiles des Bauelementes 9 an. Durch das Einrasten der Nasen 10 beispielsweise in eine Aussparung des Bauelementes 9 oder des Wärmeverteilers 8, wird der Kühlkörper 1 arretiert. Er bleibt dabei jedoch unter Vorspannung. Somit werden die Kontaktflächen zuverlässig auf den Wärmeverteiler 8 angedrückt.

Figur 4 zeigt, wie eine Nase 10 beispielsweise in einer Aussparung des elektronischen Bauelementes 9 eingreift.

Figur 5 zeigt eine Unteransicht des Kühlkörpers. Die nach außen gebogenen Enden der Schultern 6 sind genauso wie die Lappen 7 sichtbar. Die Kontaktflächen 2 erscheinen in ihren Umrissen als Rechtecke. Die Längsrichtung 5 des Kühlkörpers 1 ist durch einen Doppelpfeil angezeigt. Die Breite des Messingblechstreifens ergibt sich ungefähr aus der Breite des Bauelementes 9, dem Abstand je zwischen Bauelement und Lappen 7 und der zweifachen Breite der Lappen 7.

Durch die konstruktive Gestaltung in Mäanderform hat der Kühlkörper 1 die notwendige Längselastizität. Diese ist notwendig, um ihn auf dem Bauelement 9 zu montieren. Die Schultern 6 des Kühlkörpers zentrieren diesen jederzeit auf dem Bauelement 9. Darüber hinaus werden die Kontaktflächen durch diese Zentrierung relativ zu den Kontaktflächen des Wärmeverteilers 8 positioniert. Dies gilt sowohl für die Montage, als auch für ein Wiederzentrieren nach dem Einwirken von äußeren Kräften auf den Kühlkörper im montierten Zustand.

Ist der Kühlkörper 1 aufgesetzt, aber noch nicht über die Schnappverbindung montiert, so sitzen die Innenkanten 3 der Kontaktflächen 2 zunächst alleine auf. Die Außenkanten 4 der Kontaktflächen 2 sind in diesem Zustand geringfügig von dem Wärmeverteiler 8 beabstandet. Durch Herstellung der Schnappverbindung mittels der Nasen 10 des Kühlkörpers werden auch die Außenkanten 4 der Kontaktflächen 2 des Kühlkörpers 1 auf den Wärmeverteiler 8 gezogen. Somit wird ein zuverlässiger Kontakt zur Wärmeabfuhr hergestellt.

Weitere Vorteile des Kühlkörpers bestehen darin, daß er beispielsweise auf verschiedene Art und Weisen zur Montage angeboten werden kann. Dies kann beispielsweise in Stangenmagazinen geschehen, oder in Coils, wobei der Kühlkörper hierbei unmittelbar vor der Montage freigestanzt werden muß.

Ein weiterer Vorteil besteht darin, den Date-Code des Power-SMD-ICs noch einsehen bzw. lesen zu können, wenn sich der Kühlkörper 1 auf dem Bauelement 9 befindet. Dies ist auf Grund der mäanderförmigen Ausbildung des Kühlkörpers 1 möglich. Dabei werden Beschriftung des Bauelementes und Ausbildung des Kühlkörpers derart aufeinander abgestimmt, daß die Beschriftung zwischen zwei unteren Mäanderbögen 11 zum Liegen kommt.

Ein weiterer Vorteil des erfindungsgemäßen Kühlkörpers besteht in der automatischen Montier- und Demontierbarkeit. Der Kühlkörper kann auch von Hand, d.h. ohne Werkzeug, montiert und demontiert werden, weil die Fügekräfte relativ gering sind.

Die Elastizität des Kühlkörpers 1 bleibt auch erhalten, wenn er im montierten Zustand Wärmebehandlungsprozesse durchläuft. Durch die relativ geringen Fügekräfte F werden weder Bauelement 9, noch dessen elektrische Anschlußelemente 13 beschädigt.

Kollisionen mit dem Kühlkörper 1 führen nicht sofort zu einer Beschädigung des Systemes, da der Kühlkörper auf Grund seiner Längselastizität ausweichen kann. Somit werden die Lötstellen, mit denen das Bauelement 9 beispielsweise auf einer Leiterplatte befestigt ist, weniger beansprucht, als wenn der Kühlkörper 1 aufgeklebt oder aufgelötet wäre.

Neben der Längselastizität in Richtung der Längsrichtung 5 des Kühlkörpers 1 kann auf Grund der seitlich ausgebildeten Lappen 7 der Kühlkörper ebenso mechanische Einwirkungen in Richtungen, die quer zur Längsrichtung 5 verlaufen, aufnehmen bzw. abfangen.

## Patentansprüche

1. Bauelementadaptierter Kühlkörper, der mit einer Schnappverbindung auf einem mit einem Wärmeverteiler (8) versehenen elektronischen Bauelement (9) befestigt ist, zur zumindest teilweisen Kontaktierung mit einer Kontaktfläche (2) an dem Wärmeverteiler (8) des elektronischen Bauelements (9) zur Wärmeabfuhr über Kühlflächen des Kühlkörpers (1) nach außen, bei hergestellter Schnappverbindung zwischen Kühlkörper (1) und Bauelement (9), bestehend aus einem mäanderförmig gebogenen metallischen Streifen mit an den Wärmeverteiler (8) angrenzendem mindestens einen unteren Mäanderbogen (11), der mindestens eine Kontaktfläche (2) darstellt und mit dem mindestens einen unteren Mäanderbogen (11) gegenüberliegenden oberen Mäanderbögen (12), die von dem Wärmeverteiler (8) weggerichtet sind,
wobei am Kühlkörper (1) im Bereich des mindestens einen unteren Mäanderbogens (11) Schultern (6) und Lappen (7) zur Positionierung des Kühlkörpers (1) relativ zum Bauelement (9) derart ausgebildet sind, dass sie an den oberen Umriss des Bauelements (9) angepaßt sind, so dass sie bei hergestellter Schnappverbindung mit diesem zusammenwirken,
wobei die beiden unteren äußeren Enden des Kühlkörpers (1) mit nach innen und aufwärts gebogenen Nasen (10) versehenen sind und die Enden sich bei hergestellter Schnappverbindung seitlich vom Bauelement (9) nach unten hin bis zu einer Unterkante oder Aussparung am Bauelement (9) erstrecken,
wobei der Kühlkörper (1) bei hergestellter Schnappverbindung mit der mindestens einen Kontaktfläche (2) teilweise oder vollständig auf dem Wärmeverteiler (8) aufsitzt,
wobei die Nasen (10) des Kühlkörpers an der Unterseite des Bauelements (9) oder an der Unterseite einer Aussparung im Kühlkörper (1) angreifen und bei hergestellter Schnappverbindung die Verformung zumindest der äußeren oberen Mäanderbögen (12) dazu dient, die mindestens eine untere Kontaktfläche (2) gegen den Wärmeverteiler (8) anzudrücken, so dass der Kühlkörper (1) selbst zentrierend und stabil gegen Ablösung und Verschiebung montiert ist.

2. Kühlkörper nach Anspruch 1, worin der Kühlkörper (1) aus einem Streifen aus Messingblech besteht.

3. Kühlkörper nach Anspruch 1 oder 2, worin der zur Herstellung des Kühlkörpers (1) verwendete mäanderförmig gebogene Streifen bei hergestellter Schnappverbindung an den Mäanderbögen Biegungen mit ungefähr 90° aufweist.

## Claims

1. A component-adapted heat sink which is mounted by means of a snap-action connection on top of an electronic component (9) which is provided with a heat distributor (8) so as to make at least partial contact with a contact surface (2) on the heat distributor (8) of the electronic component (9) for the purpose of external heat dissipation via cooling surfaces of the heat sink (1) to the outside when the snap-fit connection between heat sink (1) and component (9) is established, consisting of a meander-shaped bent metallic strip having at least one lower meandering curve (11) adjoining the heat distributor (8) and representing at least one contact surface (2) and having opposite to the at least one lower meandering curve (11) upper meandering curves (12) which are directed away from the heat distributor (8),
wherein on the heat sink (1), in the region of the at least one lower meandering curve (11), shoulders (6) and lugs (7) are formed for positioning the heat sink (1) relative to the component (9) such that they are matched to the upper outline of the component (9) so that they interact with the latter when the snap-fit connection is established,
wherein the two lower outer ends of the heat sink (1) are provided with tabs (10) which are bent inwards and upwards and when the snap-fit connection is established the ends extend laterally from the component (9) downwards as far as a lower edge or cutout on the component (9),
wherein the heat sink (1) rests with its at least one contact surface (2) partially or fully on the heat distributor (8) when the snap-fit connection is established,
wherein the tabs (10) of the heat sink lock onto the underside of the component (9) or onto the underside of a cutout in the heat sink (1) and when the snap-fit connection is established the deformation at least of the outer upper meandering curves (12) serves to press the at least one lower contact surface (2) against the heat distributor (8), with the result that the heat sink (1) is mounted so as to be self-centring and stable against detachment and displacement.

2. The heat sink according to claim 1, wherein the heat sink (1) consists of a strip made of brass sheet.

3. The heat sink according to claim 1 or 2, wherein the strip bent into a meander shape and used to produce the heat sink (1) has bends at approx. 90° at the meandering curves when the snap-fit connection is established.

## Revendications

1. Dissipateur thermique adapté aux composants, qui est fixé par une liaison par encliquetage sur un composant électronique (9) muni d'un lingot de la chaleur (8), et prévu pour établir un contact au moins partiel avec une surface de contact (2) sur le lingot de la chaleur (8) du composant électronique (9) en vue de dissiper la chaleur vers l'extérieur par l'intermédiaire de surfaces de refroidissement du dissipateur thermique (1), lorsque la liaison par encliquetage est établie entre le dissipateur thermique (1) et le composant (9), composé par une bande métallique cintrée en forme de méandre avec au moins une courbe inférieure du méandre (11), contiguë au lingot de la chaleur (8), qui constitue au moins une surface de contact (2), et avec au moins une courbe supérieure du méandre (12), qui est située en face de la au moins une courbe inférieure du méandre (11) et qui s'écarte du lingot de la chaleur (8),
des épaulements (6) et des ailettes (7) étant prévus sur le dissipateur thermique (1 ), dans la zone de la au moins une courbe inférieure du méandre (11), en vue de positionner le dissipateur thermique (1) par rapport au composant (9), de telle manière qu'ils soient adaptés au contour supérieur du composant (9) de telle sorte qu'ils ont une interaction avec celui-ci lorsque la liaison par encliquetage est établie,
les deux extrémités inférieures extérieures du dissipateur thermique (1) étant munies de talons (10) courbés vers l'intérieur et vers le haut et les extrémités se développant, lorsque la liaison par encliquetage est établie, sur les côtés du composant (9) vers le bas jusqu'à une arête inférieure ou un évidement du composant,
le dissipateur thermique (1) étant appliqué, lorsque la liaison par encliquetage est établie, avec au moins une surface de contact (2), partiellement ou complètement, sur le lingot de la chaleur (8),
les talons (10) du dissipateur thermique s'engageant sous la face inférieure du composant (9) ou sous la face inférieure d'un évidement dans le dissipateur thermique (1) et, lorsque la liaison par encliquetage est établie, la déformation de au moins les courbes (12) supérieures extérieures du méandre servant à presser au moins une surface de contact inférieure (2) contre le lingot de la chaleur (8), si bien que le dissipateur thermique se centre de lui-même et est empêché de se dégager et de se déplacer.

2. Dissipateur thermique selon la revendication 1 dans lequel le dissipateur thermique (1) est constitué par une bande en tôle de laiton.

3. Dissipateur thermique selon la revendication 1 ou 2 dans lequel la bande cintrée en forme de méandre utilisée pour la fabrication du dissipateur thermique (1) comporte, lorsque la liaison par encliquetage est établie, des coudes d'environ 90° sur les courbes du méandre.
